## Europäisches Patentamt

## European Patent Office

## Office européen des brevets

(11) Publication number: **0 013 088**
**B2**

# NEW EUROPEAN PATENT SPECIFICATION

(45) Date of publication of the new patent specification: **23.06.89**

(21) Application number: **79302813.5**

(22) Date of filing: **06.12.79**

(51) Int. Cl.⁴: **H 01 L 27/02,** H 01 L 21/66, G 01 R 31/28

(54) Very large-scale integration semiconductor circuit.

(30) Priority: **29.12.78 JP 165064/78**

(43) Date of publication of application:
**09.07.80 Bulletin 80/14**

(45) Publication of the grant of the patent:
**21.03.84 Bulletin 84/12**

(45) Mention of the opposition decision:
**23.06.89 Bulletin 89/34**

(84) Designated Contracting States:
**DE FR GB**

(73) Proprietor: **FUJITSU LIMITED, 1015, Kamikodanaka Nakahara- ku, Kawasaki- shi Kanagawa 211 (JP)**

(72) Inventor: **Kikuchi, Hideo, 1528 Takada- cho Kohoku- ku, Yokohama- shi Kanagawa 223 (JP)**
Inventor: **Hoshikawa, Ryusuke, 21- 13, Yokodai 1-Chome, Sagamihara- shi Kanagawa 229 (JP)**

(74) Representative: **Massey, Alexander, MARKS & CLERK Suite 301 Sunlight House Quay Street, Manchester, M3 3JY (GB)**

(56) References cited:
DE-A-2 203 859
DE-B-1 487 398
GB-A-2 011 706

IBM TECHNICAL DISCLOSURE BULLETIN, vol. 18, no. 6, November 1975, New York, USA, J.D. McKINNON: "Active circuit for neutralizing capacitive loading", pages 1933-1934
IBM TECHNICAL DISCLOSURE BULLETIN, vol. 18, no. 8, January 1976, New York, USA, Y.R. GOPALAKRISHNA et al. "Driver circuit", pages 2513-2514
IEEE JOURNAL OF SOLID-STATE CIRCUITS, vol. SC-13, no. 5, October 1978, New York, USA, O. TOMISAWA: "A 920 gate DSA MOS Masterslice", page 536-541
1977 IEEE International Solid-State Circuits Conference-Digest of Technical Papers, February 1977, pages 142-145 and 248

(56) References cited: (continuation)
IEEE Journal of Solid-State Circuits, Vol. SC-8, No. 5, October 1973, pages 310-318
1978 IEEE International Solid State Circuits Conference-Digest of Technical Papers, February 1978, pages 66 and 67
Charles Botchek: "MOS/LSI Basic Device Design and Integrated Circuit Design", Botchek Associates, Saratoga, Calf., 1973, pages 17/18 to 17/26
1977 IEEE International Solid-State Circuits Conference-Digest of Technical Papers, February 1977, pages 12 and 13.

## Description

## Very large-scale integration semiconductor circuit

The present invention relates to a very large-scale integration semiconductor circuit.

A commonly used large-scale integration (LSI) circuit is fabricated as a single silicon chip having the size of 5 through 10 mms square. However, in a future computer system, a very large-scale integration (VLSI) circuit adapted to a big computer system including a multicomputer system, will be commonly used. In this case, the VLSI circuit may be fabricated as a single silicon chip having the size of 20 through 30 mms square. In view of the architecture for designing the LSI circuit, when the circuit is constructed by a conventional LSI circuit including no more than several thousands of logic gates, the amount of information for the design is relatively small. This is because the information contains only the information for designing the logic circuit arrangement so as to obtain the desired logic operation. However, when the circuit is constructed with the VLSI circuit including more than several ten thousands of logic gates, the amount of information for the design becomes considerably large. This is because the information must contain not only the information for designing the logic circuit arrangement so as to obtain the desired logic operation, but also the information for designing a layout of a great number of the logic circuits to be distributed in the single silicon chip. Above all, the latter information for designing the layout of the logic circuits is very important information in view of the architecture for designing the VLSI circuit. The reason for the above mentioned fact is as follows. Generally, the delay of time for transferring each data signal depends on the length of the respective distributing line on which the data signal is transferred, because the delay of time is proportional mainly to the length of the distributing line due to the presence of the stray capacity created along the distributing line. In the VLSI circuit, since the distributing lines are mounted on and inside the very wide surface of the single silicon chip, the difference between the length of a long distributing line and the length of a short distributing line becomes a very large value, such as, for example several tens mms. Therefore, the difference between the delay of time regarding the data signal transferred on the long distributing line and the delay of time regarding the data signal transferred on the short distributing line is great. Consequently, the characteristics of the VLSI circuit to be fabricated are strongly dependent upon the location of each logic circuit on the surface of the single silicon chip. In other words, the characteristics of the VLSI circuit vary in accordance with the layout of a great number of the logic circuits. This is the reason why the information for designing the layout is very important information.

However, since there are a great number of logic gates, such as several ten thousands of logic gates on one single silicon chip, it is very difficult for a VLSI circuit designer to determine the respective optimum locations on the chip with respect to most of the logic gates. Further, it takes an extremely long time for him to complete the design of such a layout. According to conventional architecture for designing the layout of the logic gates, the VLSI circuit designer proceeds with the design work through a so-called trial and error mode. That is, in an initial step, he completes, on trial, the design of the layout. Next, he investigates whether or not each data signal is transferred on the respective distributing line within the respective optimum delay of time. Then, he shortens the length of one or more distributing lines which produce the longer delay of time compared to the respective predetermined optimum delay of time, and rearranges the location of each of the corresponding logic gates so as to obtain the respective optimum delay of time. Thus, he completes the design of the layout regarding one VLSI circuit. Therefore, as previously mentioned it takes an extremely long time for him to complete the design of such a layout. Besides, if it is required later to modify the design of at least one part of the logic circuits, he has to restart designing a new layout in the same manner as the manner mentioned above, i.e. through a trial and error mode.

From the IEEE journal of Solid-State Circuits, Volume SC-13, no. 5, October 1978, pages 534 - 541 there is known a large-scale integration semiconductor circuit, comprising: a plurality of functional blocks, each functional block conducting a respective one of the desired functions to be conducted by the large-scale integration semiconductor circuit, and the functional blocks being located at respective different regions from each other on one single silicon chip on which the large-scale integration semiconductor circuit is mounted; output driving means and; distributing lines which connect one functional block with the other corresponding functional blocks and are formed on said single silicon chip.

However, in the known circuit the lengths of the distribution lines interconnecting the functional blocks vary considerably and as a result the delay times caused by stray capacity vary from one distribution line to another. These delays determine for example the time taken for data to be fed from one functional block to another and the designer must therefore adjust the length of the distribution lines to ensure that various functional operations are completed in the available time.

Therefore, it is an object of the present invention to provide a VLSI semiconductor circuit having a circuit construction which enables the VLSI designer to carry out the design of the logic circuits and also the layout thereof very easily and in a very short time.

According to the present invention there is provided a very large-scale integration semiconductor circuit, comprising: a plurality of functional blocks acting, at least, as a storage unit, an arithmetic and logical unit, a register file, an interface control unit, a program ROM (read only memory) and an instruction decoder, each functional block conducting a respective one of the desired functions to be conducted by the very large-scale integration semiconductor circuit, the functional blocks being located at respective different regions from each other on one single silicon chip on which the very large-scale integration semiconductor circuit is mounted, and the functional blocks being interconnected by distribution lines formed on the chip, characterised in that high power output driving means are employed in output stages of each functional block, the high power output driving means being fabricated as high power driving output logic gates which act, at the same time, as circuit components of logic circuits comprising each functional block, and the high power driving output logic gates being larger in size and capacity, as compared to the other logic gates which constitute the same logic circuits.

The high power output driving means result in the delay times on the distribution lines being greatly reduced. This is because the electric charge supplied to the distribution lines very rapidly charges the stray capacity along the lines. The designer can thus effectively disregard delay times resulting from stray capacity on the distribution lines.

The present invention will be more apparent from the ensuing description with reference to the accompanying drawings wherein:

Fig. 1 illustrates a schematic plan view of divided functional blocks taking, for example, a computer system, according to the known technology; (e.g. IEEE Intern. Solid-State Circuits Conference Digest of Technical Paper, February 1977, pages 142 to 143 and 148);

Fig. 2 depicts a timing chart of data signals appearing in members 12, 14, 16 and 17 shown in Fig. 1;

Fig. 3 illustrates a schematic plan view of the members 11 through 17 shown in Fig. 1 being provided with the respective distributing lines, according to the present invention, and;

Fig. 4 illustrates a schematic plan view of one example of logic gates mounted on one functional block, according to the present invention.

The VSLI semiconductor circuit according to the present invention is fabricated based on two important conditions. A first condition thereof is a division of the VSLI circuit. A second condition thereof is employment of high power output driving means. Regarding the first condition, the VSLI circuit is divided into several blocks from a view point of several kinds of functions to be performed in the VLSI circuit. In other words, the VLSI circuit is divided into several functional blocks. It should be noted that the VLSI circuit is divided, at the same time, into said several functional blocks which are located at respective different parts on the single silicon chip. Therefore, each of the functional blocks forms a semiconductor island on the chip. Since the VLSI circuit is the combination of the independent functional blocks, the VLSI circuit designer can design the logic circuits and also the layout thereof with respect to every function block independently, irrespective of the presence of the other functional blocks. It should be understood that it is very easy for the VLSI circuit designer to design the logic circuits and also the layout thereof only with respect to each one of the functional blocks. This is because each of the divided functional blocks has a size being substantially equal to the size of the conventional MS (medium-scale integration) semiconductor circuit or the conventional LSI semiconductor circuit, both of which contain no more than several ten thousands of logic gates.

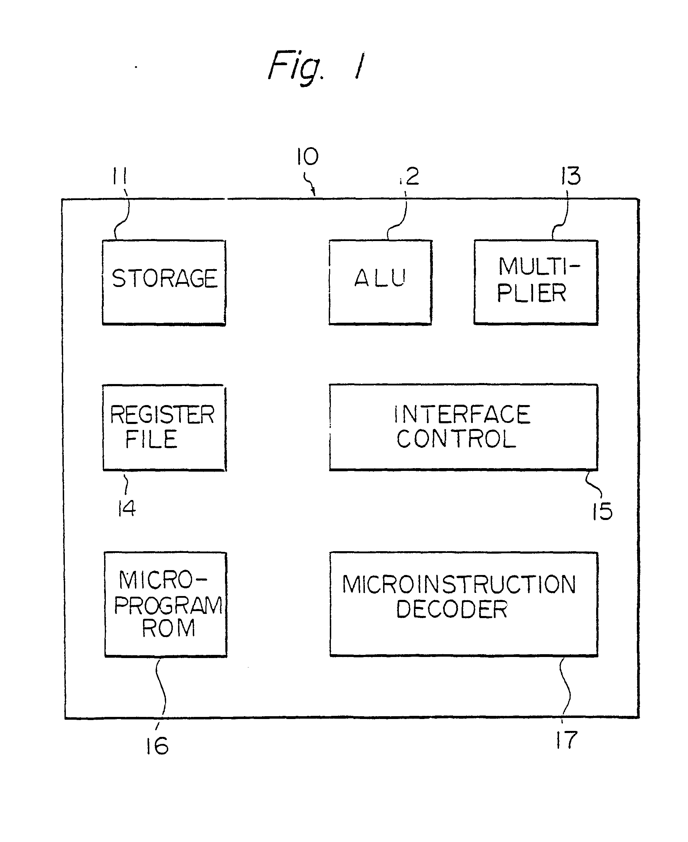

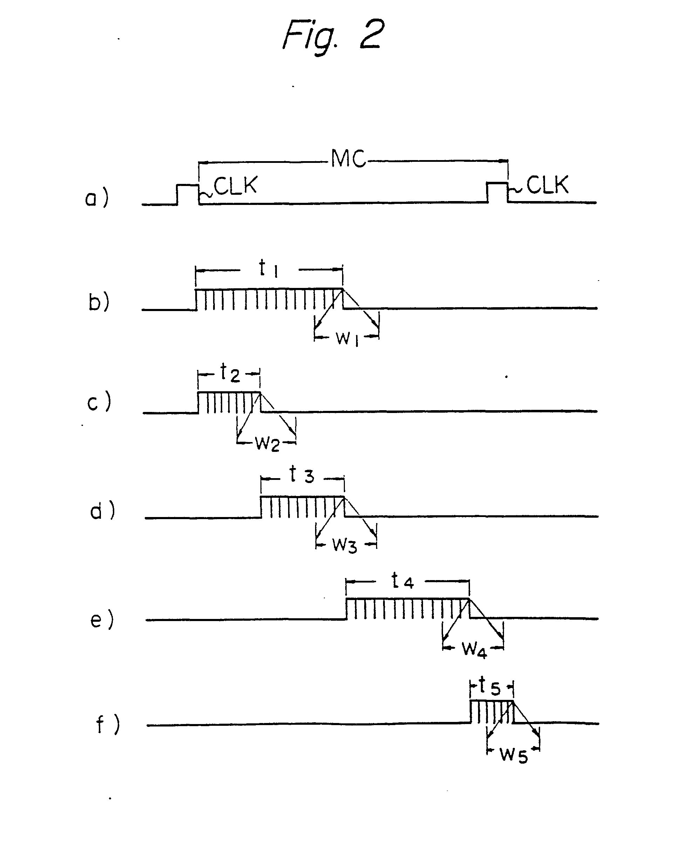

In Fig. 1, which illustrates a schematic plan view of the divided functional blocks, taking for example a typical computer system, the reference numeral 10 represents a single silicon chip comprising a VLSI semiconductor circuit therein. The VLSI semiconductor circuit is comprised of seven different functional blocks 11 through 17. The functional block 11 corresponds to a storage unit, 12 to an ALU (arithmetic and logical unit), 13 to a multiplier, 14 to a register file unit, 15 to an interface control unit, 16 to a microprogram ROM (read only memory) and 17 to a microinstruction decoder. One example of the logic operations conducted in the chip 10 is as follows. The ALU 12, the register file unit 14, the microprogram ROM 16 and the microinstruction decoder 17, which decoder 17 includes a microinstruction register (not shown) and a decoding circuit (not shown), cooperate with each other, so that the following operation is performed. Referring to Fig. 2, which depicts a timing chart of signals appearing in the above mentioned members, row a) indicates a conventional system clock signal (CLK) to be applied to the microinstruction decoder 17 and the register file unit 14. The term of the machine cycle (MC) is fixedly defined by two clock signals. Row b) indicates a term t1 in which the decoding circuit of the microinstruction decoder 17 supplies the gist of the function to be conducted in the ALU 12, based on the output data stored in the microinstruction register, which output data has been given from the microprogram ROM 16. Row c) indicates a term t2 in which the decoding circuit supplies an address data signal to the register file 14. Row d) indicates a term t3 in which the register file 14 supplies register data to the ALU 12, which register data was specified by said address data signal. Row e) indicates a term t4 in which the ALU 12 processes said register data according to said function specified in said term t1. Row f) indicates a term t5 in which the ALU 12 feeds the resultant data to the register file 14. It should be noted the total length of terms t1 (= t2 + t3), t4 and t5 must be equal to or less than the length of the machine cycle. Accordingly, the VLSI circuit designer has to design each functional block so as to carry out the respective functional operation within a predetermined respective length of term. Therefore, he may adjust the lengths of the distributing lines or modify the circuit arrangement with respect to each functional block so as to carry out the respective functional operation within said predetermined respective length of term.

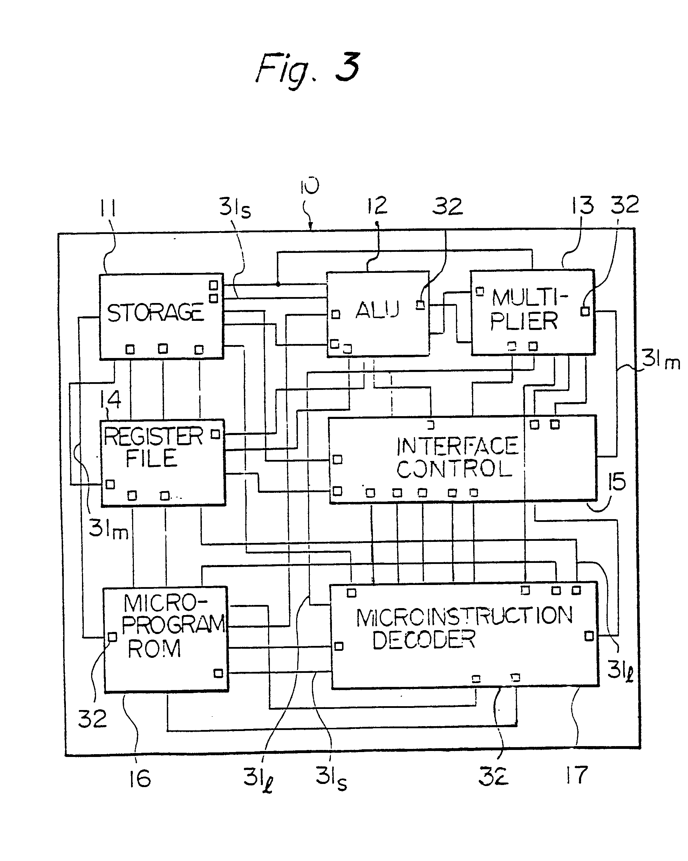

However, in the VLSI circuit, one functional block is connected to the other corresponding functional block via considerably long or short distribution lines, and accordingly, the delay of time may vary within very wide range of time, in accordance with the variation of the lengths of the distribution lines. In Fig. 3, which illustrates a schematic plan view of the divided functional blocks shown in Fig. 1 being provided with distributing lines, the functional blocks 11 through 17 are connected with each other by means of the distributing lines $31_l$, $31_m$ and $31_s$. The lines $31_l$ represent lines each of which is relatively long in length. The lines $31_m$ represent lines each of which has medium length of line. The lines $31_s$ represent lines each of which is relatively short in length. As seen from Fig. 3, the lengths of the distributing lines vary within a very wide range of length. Therefore, the stray capacities of the respective distributing lines also vary within a very wide range of values. In other words, the delay of time of the respective distributing lines vary within a very wide range of time. Consequently, although the VLSI circuit designer can easily adjust the delay of time with respect to each one of the functional blocks, he cannot easily adjust the delay of time with respect to the combination of the functional blocks. Specifically, in Fig. 2, each end of the terms t1 through t5 may vary within wide ranges (w1 through w5) of time, and thus, it is very difficult to adjust the total length of terms t1 (= t2 + t3) t4 and t5 to be equal to the length of the machine cycle MC, with respect to the combination of the functional blocks.

For the purpose of eliminating the above mentioned difficulty for adjusting the delay of time in the present invention, the previously mentioned second condition is also necessary simultaneously, besides the above explained first condition. The second condition is employment of high power output driving means. The high power output driving means are schematically illustrated, in Fig. 3 by black boxes represented by the reference numerals 32. When a data signal is transmitted to the distributing line via the high power output driving means 32, the delay of time is reduced to a considerably small value due to the presence of the driving means 32. This is because the electric charges of the data signal, being driven by the driving means, are very quickly charged in the stray capacity created along the distributing line, and accordingly the delay of time becomes very small. If no such driving means is employed, it would take a very long time for charging up the stray capacity, and accordingly, the delay of time becomes very large. Thus, when the VLSI circuit designer designs the layout of the functional blocks 11 through 17, he can disregard the variation of the respective delay of time induced by the respective distributing lines. Therefore, he can locate the functional blocks anywhere on the chip 10 at his will during the design of the layout. Consequently, the total delay of time occurring in the combination of the functional blocks is determined by merely the sum of the delay of time, which occurs in the respective functional blocks. Accordingly, as the VLSI circuit designer completes the design of each functional block so as to have the delay of time which is smaller than the predetermined respective delay of time, the combination of the functional blocks comprising the VLSI circuit can operate normally an no malfunction will occur therein. In this case, as previously mentioned, it is very easy for him to design each functional block so as to have the delay of time which is smaller than the predetermined respective delay of time, because each functional block at most has the size of the MSI or LSI.

The high power output driving means 32 are constituted by the logic gates which are located at the output stages of each functional block. The logic gates, which are located at the output stages, are used as components themselves of both the logic circuit and the high power output driving means, simultaneously. Accordingly, the logic gates which also act as the high power output driving means, are fabricated to be larger in size and capacity as compared to the similar logic gates, which act only as the conventional logic gates. The high power output driving logic gates may be INVERTERS, ORs, ANDs, NORs, NANDs, FLIP-FLOPS or TRI-STATE BUFFERS and so on.

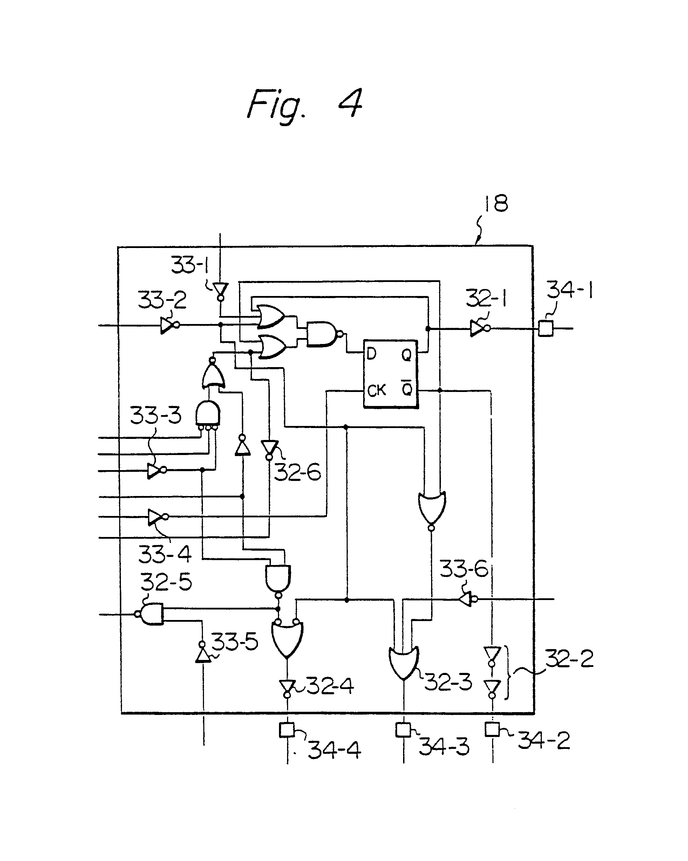

In Fig. 4, which illustrates a logic circuit diagram, of some functional block, the logic gates represented by the reference numerals 32-1 through 32-6 are the logic gates acting as the high power output driving means. It should be understood that Fig. 4 is drawn only for explaining the arrangement of logic gates, and accordingly, the logic circuit of Fig. 4 provides no meaningful logic function. The gates 32-1, 32A and 32-6 represent INVERTERS. Although the logic gate 32-6 is not located at the periphery area of the function block 18 (not shown in Figs. 1 and 3) but located at the center area thereof, the logic gate 32-6 is one of the high power output driving means, because the logic gate 32-6 functions as the output gate in the output stage. The logic gate 32-3 represents the OR. The logic gate 32-5 represents the NAND. The above mentioned logic gates 32-1 and 32-3 through 32-6 act as both the components themselves of the logic circuit and the high power output driving means, simultaneously. However, the logic gate 32-2, which is a thru INVERTER, acts as not a logic gate for conducting logic operation, but a logic gate only for serving as the high power output driving means.

As seen from Fig. 4, it is preferable to distribute the high power output driving means all over the periphery areas of the functional block 18 uniformly. This is because, in a first step, the design of each functional block is conducted, and in a second step, the design of the layout of all the functional blocks is conducted, it is not known, in the first step, where the functional blocks will be located on the chip 10 when the VLSI circuit designer starts conducting the design of each functional block. If the driving means was designed, in advance, so as to be located all over the periphery areas of the functional block 18 uniformly, each functional block can smoothly be connected to the other corresponding functional blocks via the distributing lines having a relatively short length, wherever the functional blocks are located on the chip 10 according to the design of the layout being conducted later. It is preferable that each of said driving means is further provided with many identical driving means to be located all over the periphery areas of the functional block 18 uniformly. In the same sense as mentioned above, it is also preferable to distribute input logic gates, such as gates 33-1 through 33-6 in Fig. 4, all over the periphery areas of the functional block 18. It is preferable that each of said input logic gates is further provided with many identical input logic gates to be located all over the periphery areas of the functional block 18 uniformly.

It is not always necessary to employ the high power output driving means in all of the output gates. If, for example, the logic gate 32-2 shown in Fig. 4, is connected to the other functional block via a distributing line being very short in length, it is not necessary to fabricate the output logic gate 32-2 as the high power output driving logic gate. This is because such a very short distributing line has a very small stray capacity, and accordingly, the delay of time for transferring the data signal may also be very small. In this case, such an output logic gate can be removed from the functional block, and accordingly, the functional block may be designed so as to be relatively small in size.

Further, it is possible, if necessary, to mount a checking pad comprised of a conductive material, such as aluminum. In Fig. 4, the reference numerals 34-1 through 34A represent the checking pads located close to the respective output logic gates. The checking pads can be utilized for checking or testing the operational performance of the functional block. Each checking pad has a size which is wide enough to accommodate the end of a microprobe for checking. Generally, such a checking pad has a considerably large stray capacity between the checking pad itself and the substrate of the chip. However, such a considerably large stray capacity of the checking pad can be disregarded due to the presence of the high power output driving means.

As explained above in detail, the VLSI circuit according to the present invention produces the following three major advantages.

1) The VSLI circuit designer can design every functional block independently of the other functional blocks. This is because, he can disregard the variation of the respective delay of time induced by the respective distributing lines, and accordingly the operational characteristic of each functional block is not effected by the remaining functional blocks, no matter where the functional block is located in the combination of the functional blocks. In short, the operational characteristic of any one of the functional blocks is irrespective of the location of the functional block on the single silicon chip.

2) The VLSI circuit designer can design the VLSI circuit step by step in accordance with the typical design process performed in the design of the LSI or MSI circuit. In a first step, he designs logic circuits of each functional block; however, he must take care of only the condition that the total delay of time occurring in each functional block is limited within a predetermined range of time. In a second step, he designs the layout of each functional block independently of the operational performances of the other functional blocks. The reason for this fact is apparent from the advantage mentioned in the above paragraph 1).

3) In a case where a modification of design is required later with respect to one of the functional blocks, the VLSI circuit designer is not required to modify the designs of the other functional blocks, but to modify only the functional block which needs to be modified. The reason for this fact is apparent from the advantage mentioned in the above paragraph 1).

## Claims

1. A very large-scale integration semiconductor circuit, comprising: a plurality of functional blocks (11 - 17) acting, at least, as a storage unit (11), an arithmetic and logical unit (12), a register file (14), an interface control unit (15), a program ROM (read only memory) (16) and an instruction decoder (17), each functional block conducting a respective one of the desired functions to be conducted by the very large-scale integration semiconductor circuit, the functional blocks being located at respective different regions from each other on one single silicon chip on which the very large-scale integration semiconductor circuit is mounted, and the functional blocks being interconnected by distribution lines formed on the chip, characterised in that high power output driving means (32) are employed in output stages of each functional block, the high power output driving means being fabricated as high power driving output logic gates which act, at the same time, as circuit components of logic circuits comprising each functional block, and the high power driving output logic gates being larger in size and capacity, as compared to the other logic gates which constitute the same logic circuits.

2. A circuit as set forth in claim 1, wherein the high power output driving means (32) are uniformly distributed all over the peripheral areas of each functional block.

3. A circuit as set forth in claim 1, wherein each of the high power output driving means is comprised of many identical high power output driving logic gates distributed uniformly all over the peripheral areas of each functional block.

4. A circuit as set forth in claim 1, 2 or 3, wherein at least one of the high power output driving means associated with a functional block is removed from that functional block where it is decided in advance that said at least one output (32-2) is to cooperate with very short distributing lines.

5. A circuit as set forth in claim 1, 2, 3 or 4, wherein checking pads (34-1 to 34-4) are mounted on the distributing lines of the respective high power output driving means, the checking pads being utilised for checking or testing the operational performance of the corresponding functional block.

**Patentansprüche**

1. Hochintegrierte Halbleiterschaltung mit einer Anzahl von Funktionsblöcken (11 - 17), welche wenigstens als eine Speichereinheit (11), eine arithmetische und logische Einheit (12), eine Registerdatei (14), eine Schnittstellensteuereinheit (15), ein Programm-ROM (Festspeicher) (16) und ein Befehlsdekoder (17) arbeiten, wobei jeder Funktionsblock eine entsprechende der gewünschten Funktionen durchführt, die von der hochintegrierten Halbleiterschaltung durchgeführt werden sollen, und wobei die Funktionsblöcke an entsprechenden voneinander verschiedenen Bereichen auf einem einzigen Siliziumchip angeordnet sind, auf welchem die hochintegrierte Halbleiterschaltung angeordnet ist, und die Funktionsblöcke durch Verteilungsleitungen, die auf dem Chip gebildet sind, miteinander verbunden sind, dadurch gekennzeichnet, daß Hochleistungs-Ausgabeverstärker (32) in Ausgangsstufen jedes Funktionsblockes verwendet sind, die Hochleistungs-Ausgabeverstärker als Hochleistungs-Treiberausgangs-Logikglieder aufgebaut sind, welche gleichzeitig als Schaltungskomponenten von logischen Schaltungen wirken, die jeden Funktionsblock umfassen, und wobei die Logikglieder der Hochleistungs-Ausgabeverstärker in Größe und Kapazität größer als die anderen Logikglieder sind, welche dieselben logischen Schaltungen bilden.

2. Schaltung nach Anspruch 1, bei welcher die Hochleistungs-Ausgabeverstärker (32) gleichmäßig über alle peripheren Bereiche jedes Funktionsblockes verteilt sind.

3. Schaltung nach Anspruch 1, bei welcher jeder der Hochleistungs-Ausgabeverstärker aus vielen identischen Hochleistungs-Ausgabe-Logikgliedern besteht, welche gleichmäßig über alle peripheren Bereiche jedes Funktionsblocks verteilt sind.

4. Schaltung nach einem der Ansprüche 1, 2 oder 3, bei welcher wenigstens einer der einem Funktionsblock zugeordneten Hochleistungs-Ausgabeverstärker von diesem Funktionsblock entfernt ist, wenn im Vorhinein entschieden ist, daß dieser wenigstens eine Ausgang (32-2) mit sehr kurzen Verteilungsleitungen zusammenarbeiten soll.

5. Schaltung nach einem der Ansprüche 1, 2, 3 oder 4, bei welcher Prüfanschlußfelder (32-1 bis 32-4) auf den Verteilungsleitungen der entsprechenden Hochleistungs-Ausgabeverstärker angeordnet sind, welche zur Prüfung oder zum Testen des Betriebsverhaltens der entsprechenden Funktionsblöcke dienen.

**Revendications**

1. Circuit semi-conducteur à intégration à très grande échelle comprenant plusieurs blocs fonctionnels (11 - 17) jouant au moins les rôles d'une unité de mémorisation (11), d'une unité arithmétique et logique (12), d'un fichier de registre (14), d'une unité de commande d'interface (15), d'une mémoire fixe (ROM) de programme (16) et d'un décodeur d'instructions (17), chaque bloc fonctionnel effectuant l'une respective des fonctions voulues devant être effectuées par le circuit semi-conducteur à intégration à très grande échelle, les blocs fonctionnels étant placés dans des régions respectivement différentes les unes des autres sur une unique puce de silicium sur laquelle le circuit semi-conducteur à intégration à très grande échelle est monté, et les blocs fonctionnels étant interconnectés par des lignes de distribution formées sur la puce, caractérisé en ce que des moyens de commande de sortie de haute puissance (32) sont employés dans les étages de sortie de chaque bloc fonctionnel, les moyens de commande de sortie de haute puissance étant fabriqués sous forme de portes logiques de sortie de commande de haute puissance qui jouent en même temps le rôle de composants des circuits logiques constituant chaque bloc fonctionnel, et les portes logiques de sortie de commande de haute puissance étant d'une taille et d'une capacité plus grandes par comparaison aux autres portes logiques qui constituent les mêmes circuits logiques.

2. Circuit selon la revendication 1, où les moyens de commande de sortie de haute puissance (32) sont uniformément répartis sur toutes les aires périphériques de chaque bloc fonctionnel.

3. Circuit selon la revendication 1, où chacun des moyens de commande de sortie de haute puissance est constitué de nombreuses portes logiques de commande de sortie de haute puissance identiques uniformément réparties sur toutes les aires périphériques de chaque bloc fonctionnel.

4. Circuit selon la revendication 1, 2 ou 3, où au moins l'un des moyens de commande de sortie de haute puissance qui est associé à un bloc fonctionnel est retiré de ce bloc fonctionnel lorsqu'il a été décidé par avance que cette sortie (32-2) est destinée à coopérer avec des lignes de distribution très courtes.

5. Circuit selon la revendication 1, 2, 3 ou 4, où des plots de contrôle (34-1 à 34-4) sont montés sur les lignes de distribution des moyens de commande de sortie de haute puissance respectifs, les plots de contrôle étant utilisés pour contrôler ou vérifier le bon fonctionnement du bloc fonctionnel correspondant.

# Fig. 1

STORAGE

ALU

MULTI-PLIER

REGISTER FILE

INTERFACE CONTROL

MICRO-PROGRAM ROM

MICROINSTRUCTION DECODER

# Fig. 2

a)  MC ⌐CLK ⌐CLK

b)  $t_1$
    $w_1$

c)  $t_2$
    $w_2$

d)  $t_3$
    $w_3$

e)  $t_4$
    $w_4$

f)  $t_5$
    $w_5$

# Fig. 3

# Fig. 4